# EUROPÄISCHE PATENTSCHRIFT

(11) **EP 1 693 351 B1**
(45) Veröffentlichungstag und Bekanntmachung des Hinweises auf die Patenterteilung: **29.07.2009**
(21) Anmeldenummer: 06002960.0
(22) Anmeldetag: 14.02.2006
(51) Int. Cl.: C03C 17/36, C23C 14/58

(54) **Wärmereflektierender Belag**
Heat reflecting coating
Revêtement réflecteur de chaleur

(30) Priorität: 21.02.2005 DE 102005007826
(43) Veröffentlichungstag der Anmeldung: 23.08.2006
(73) Patentinhaber: INTERPANE Entwicklungs- und Beratungsgesellschaft mbH & Co. KG, 37697 Lauenförde (DE)
(72) Erfinder: Segner, Johannes, D.r, 88212 Ravensburg (DE); Weis, Hansjörg, Dr., 37671 Höxter (DE); Mönnekes, Jörg, 37671 Höxter (DE)
(74) Vertreter: Körfer, Thomas

(56) Entgegenhaltungen:
- EP-A- 0 464 789
- EP-A- 0 488 048
- EP-A- 0 751 099
- EP-A- 1 371 745
- EP-A- 1 538 131
- WO-A-20/04071984
- DE-A1- 10 252 101
- FR-A- 2 586 245
- US-A- 5 837 361
- US-B1- 6 797 389

## Beschreibung

Die vorliegende Erfindung betrifft einen wärmereflektierenden Belag für ein transparentes Substrat gemäß Oberbegriff des Patentanspruchs 1. Die Erfindung betrifft weiterhin ein Verfahren zu seiner Herstellung.

Niedrig-emissive Beschichtungen (Low-E-Beschichtungen) reduzieren die normale, relativ hohe Emissivität von Glas. Diese Beschichtungen sind fast vollständig transparent für das sichtbare Licht. Sie reflektieren die langwellige Infrarotstrahlung (Wärmestrahlung) an ihrer Oberfläche, womit sich eine hohe Wärmedämmung ergibt.

Herkömmlicherweise wird als wärmereflektierender Belag für ein transparentes Substrat, beispielsweise Glas, mindestens eine Silberschicht als Funktionsschicht verwendet. Die Silberschicht hat den Vorteil, daß bei hoher Transmission im sichtbaren Spektralbereich eine hohe Reflexion im Infrarotbereich, also im Bereich der Wärmestrahlung, erfolgt. Des weiteren kann unter Verwendung einer Silberschicht ein in Durchsicht und Reflexion farblich neutral wirkendes Schichtsystem realisiert werden. Eine oder mehrere Silberschichten aufweisende Schichtsysteme werden daher bei der Fahrzeugverglasung und der Gebäudeverglasung eingesetzt.

Ein wärmereflektierender Belag für ein transparentes Substrat mit einer auf dem Substrat angeordneten Schicht aus einem Zink enthaltenden Mischoxid und einer darüber angeordneten Silber enthaltenden Schicht ist beispielsweise aus der WO 01/27050 A1 bekannt. Die dort beschriebene Antireflexionsschicht weist ein Mischoxid aus Zink und mindestens einem weiteren Metall auf. Eine besonders bevorzugte Mischoxidschicht besteht aus ZnSnOₓ.

Die EP 1 371 745 A1 beschreibt ein beschichtetes Substrat, das als Unterblocker eine keramische ZnO-Schicht aufweist. Diese Schicht kann auch einen gewissen Gewichtsanteil von AlₛOₛ aufweisen.

Die EP 0 464 789 A1 beschreibt die Herstellung eines Aluminium dotierten ZnO-Films nach dem Sputterverfahren.

Derartige wärmereflektierende Beläge weisen allerdings den Nachteil auf, daß sie während ihres Herstellungsverfahrens, beispielsweise durch Magnetronsputtern, ungleichmäßig auf dem Glassubstrat aufgetragen werden, was dazu führt, daß die optische Qualität der Funktionsschicht beeinträchtigt ist, womit eine optimale Reflexion der Infrarotstrahlung (Wärmestrahlung) nicht mehr gewährleistet ist.

Es ist daher Aufgabe der vorliegenden Erfindung, einen wärmereflektierenden Belag für ein transparentes Substrat und ein Verfahren zu dessen Herstellung zur Verfügung zu stellen, wobei die Uniformität der Silberschicht gewährleistet ist und die Emission der Silberschicht erhöht ist, ohne daß ihre Schichtdicke erhöht werden muß.

Diese Aufgabe ist mit dem wärmereflektierenden Belag für ein transparentes Substrat gemäß Patentanspruch 1 und das Verfahren gemäß Patentanspruch 10 gelöst worden.

Die vorliegende Erfindung betrifft einen wärmereflektierenden Belag für ein transparentes Substrat mit einer auf dem Substrat angeordneten Schicht aus einem Zink (Zn) enthaltenden Mischoxid und einer darüber angeordneten Silber (Ag) enthaltenden Schicht, der dadurch gekennzeichnet ist, daß das Mischoxid 99,5 bis 92 Atom-% Zinkoxid (ZnOₓ) und 0,5 bis 8 Atom-% Aluminiumoxid (AlₓO_{y}) und Magnesiumoxid (MgOₓ) umfaßt, zwischen dem Substrat und der Mischoxidschicht und gegebenenfalls über der Silberschicht eine Metalloxidschicht vorgesehen ist bzw. sind, und die Metalloxidschichten Titanoxid (TiO_{X}), Zinnoxid (SnO_{X}) und/oder Zinkoxid (ZnO_{X}) umfassen.

Die Unteransprüche betreffen bevorzugte Ausführungsformen des erfindungsgemäßen wärmereflektierenden Belags.

Die Erfindung betrifft weiterhin Verfahren zur Herstellung des wärmereflektierenden Belags durch Kathodenzerstäubung, d.h. Sputtern, bevorzugt in reaktiver Atmosphäre.

Ein Ausführungsbeispiel der Erfindung wird nachfolgend unter Bezugnahme auf die Zeichnung erläutert. In der Zeichnung zeigt:

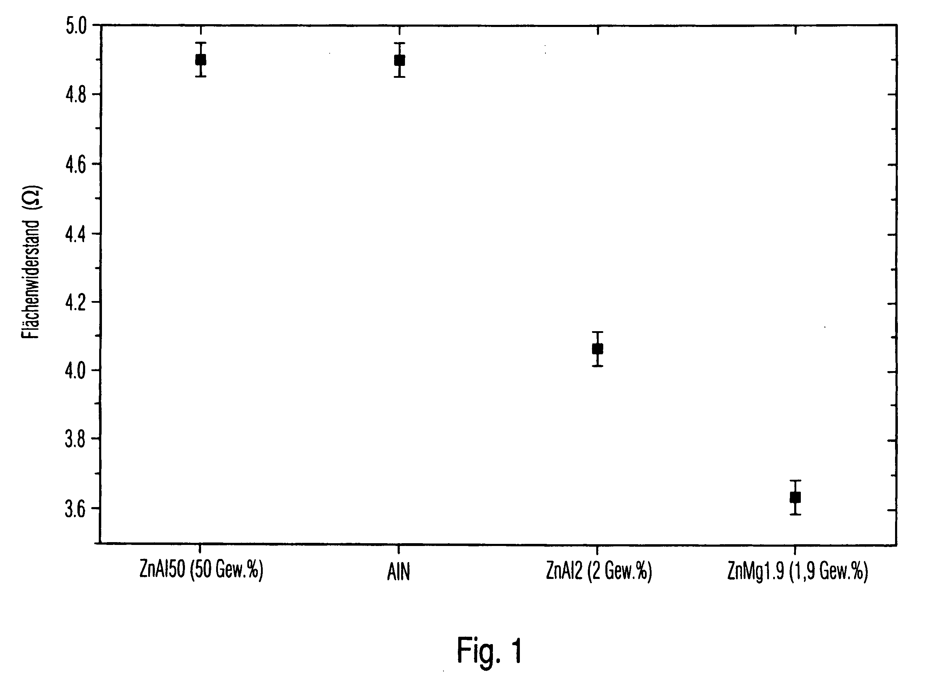

- Fig. 1: ein Diagramm, worin der gemessene Flächenwiderstand einer Silberschicht eines Schichtsystems in Abhängigkeit der Zusammensetzung der Zink-Mischoxidschicht aufgetragen ist.

Der vorliegenden Erfindung liegt die Erkenntnis zugrunde, daß die wärmereflektierenden Eigenschaften einer Silberfunktionsschicht deutlicht beeinflußt werden können durch die darunterliegende Zink enthaltende Mischoxidschicht. Die auch als Wachstumsschicht bzw. Aufwachsschicht bezeichnete Mischoxidschicht ermöglicht eine frühe Ordnung zur Gitterbildung der nachfolgend abgeschiedenen Silberfunktionsschicht. Auf diese Weise wird die Emission der Silberfunktionsschicht erhöht, ohne Erhöhung der Silberschichtdicke, was für eine ausgezeichnete Transparenz der Silberschicht von Vorteil ist.

In einer bevorzugten Ausführungsform der vorliegenden Erfindung liegt die Menge von Aluminiumoxid (AlₓO_{y}) und Magnesiumoxid (MgOₓ) in einem Bereich von 1,5 bis 6 Atom-%, insbesondere in einem Bereich von 2,5 bis 4 Atom-%.

Die auf dem Substrat abgeschiedene Mischoxidschicht weist Zusammensetzungen der Formel ZnAlMgOₓ, auf. Diese Mischoxidschichten können beispielsweise durch reaktives Sputtern eines Targets, das eine Legierung oder Mischung aus Zn und A1 und Mg umfaßt, in Gegenwart von Sauerstoff auf ein im wesentlichen flaches oder planares Substrat abgeschieden werden. Alternativ kann die Mischoxidschicht durch Sputtern eines Targets, das eine Mischung aus Zinkoxid und Aluminiumoxid und Magnesiumoxid umfaßt, insbesondere in einer Argongasatmosphäre oder einer Argongasatmosphäre, die Sauerstoff enthält, auf dem Substrat abgeschieden werden.

Bei dem transparenten Substrat handelt es sich normalerweise um Substrate, die aus Glas oder Kunststoff gebildet sind. Beispiele dafür sind Glasscheiben, insbesondere Float-Glasscheiben. Geeignet sind auch Kunststoffscheiben oder Kunststoffolien, insbesondere solche Kunststoffolien, die bei der Herstellung von Verbundglas zwischen den Glasscheiben eingefügt werden.

Die Silberfunktionsschicht besteht vorzugsweise aus Silber bzw. Mischungen aus Silber und Silberoxid. Normalerweise sollte die Silberschicht eine Dicke von 10 nm bis 25 nm aufweisen. Die Silberfunktionsschicht, die die Reflexion der Infrarot-Wärmestrahlung bewirkt, kann ebenfalls durch Sputtern auf der Zn-Mischoxidschicht ausgebildet werden.

Zwischen dem Substrat und der Zn-Mischoxidschicht ist eine Metalloxidschicht vorgesehen. Diese Schicht dient sowohl als haftvermittelnde Schicht als auch zur Entspiegelung. Die Dicke dieser Schicht liegt vorzugsweise in einem Bereich von 25 nm bis 35 nm, insbesondere in einem Bereich von etwa 30 nm. Diese dielektrische Metalloxidschicht umfaßt vorzugsweise Titanoxid (TiOₓ), Zinnoxid (SnOₓ) und/oder Zinkoxid (ZnOₓ), wobei Titanoxid besonders bevorzugt ist.

Die Metalloxidschicht wird vorzugsweise durch Sputtern reaktiv in einer Sauerstoffatmosphäre abgeschieden.

In einer bevorzugten Ausführungsform der vorliegenden Erfindung, kann über der Silberfunktionsschicht eine zweite Metalloxidschicht angeordnet sein, die die gleiche Zusammensetzung wie oben beschrieben aufweisen kann. Sie wird ebenfalls bevorzugt durch Sputtern in einer Sauerstoffatmosphäre auf die Silberschicht aufgebracht. Auch diese zweite Metalloxidschicht dient zur Entspiegelung der Silberschicht im sichtbaren Spektralbereich. Die Dicke der zweiten Metallschicht liegt ebenfalls bevorzugt zwischen 25 nm und 35 nm, insbesondere bei etwa 30 nm.

Die Fig. 1 zeigt den Einfluß der Wachstumsschicht, d.h. der Zn enthaltenden Mischoxidschicht auf die wärmereflektierenden Eigenschaften der Silberfunktionsschicht. Es wurde der Flächenwiderstand eines Schichtsystems der Abfolge Glas/Wachstumsschicht/Ag-Schicht gemessen. Der Flächenwiderstand einer Silberschicht korreliert mit dem Maß der Reflexion der Infrarot-Strahlung. Ein geringer Flächenwiderstand bedeutet eine stärkere Reflexion der IR-Strahlung.

Bei den genannten Schichtsystemen ist die Schichtdicke der Silberfunktionsschicht konstant. Folgende Aufwachsschichten wurden getestet:
a) Oxid von Zn/Al (50 Gew.-% Al)
b) AlN
c) Mischoxid von Zn:Al (2 Gew.-% Al)
d) Mischoxid von Zn:Mg (1,9 Gew.-% Mg)

Es ist festgestellt worden, daß durch Zulegierung von beispielsweise Magnesium eine Verbesserung des Flächenwiderstands der Silberschicht um 1,2 Ω im Vergleich zu handelsüblichen Zink-Mischoxidschichten erreicht werden kann. Im Fall der Zulegierung von Aluminium wird eine Verbesserung des Flächenwiderstandes um etwa 0,6 Ω erreicht, wobei insbesondere bemerkenswert ist, daß der Flächenwiderstand um etwa 0,4 bis 0,5 Ω im Fall des mit Magnesium dotierten Zinkoxids im Vergleich zum aluminiumdotierten Oxid verbessert werden kann. Besonders gute Ergebnisse lassen sich erreichen, wenn Aluminium und Magnesium zum Zinkoxid legiert werden.

Die einzelnen Schichten für den erfindungsgemäßen wärmereflektierenden Belag können durch Kathodenzerstäubung, d.h. Sputtern, vorzugsweise in reaktiver Atmosphäre, auf dem transparenten Substrat abgeschieden werden. Es wird ein Target, das eine Mischung aus Zinkoxid, Aluminium- und Magnesiumoxid enthält, verwendet. Ein Beispiel für ein reaktives Sputtern ist das Arbeiten in einem Sauerstoffplasma in Gegenwart von Argon.

In einer Ausführungsform bei der Herstellung des erfindungsgemäßen wärmereflektierenden Belags wird die Zink enthaltende Mischoxidschicht nach dem Abscheiden und vor dem Abscheiden von Silber in einem Sauerstoffplasma behandelt, um die Oberfläche der Mischoxidschicht mit Sauerstoffatomen abzusättigen.

Der erfindungsgemäße Belag eignet sich hervorragend zur Beschichtung von Gläsern (Low-E-Beschichtung) zur Wärmeisolierung von Gebäudeverglasungen und Fahrzeugverglasungen.

## Patentansprüche

1. Wärmereflektierender Belag für ein transparentes Substrat mit einer auf dem Substrat angeordneten Schicht aus einem Zink (Zn) enthaltenden Mischoxid und einer darüber angeordneten Silber (Ag) enthaltenden Schicht,
**dadurch gekennzeichnet,**
**dass** das Mischoxid 99,5 bis 92 Atom-% Zinkoxid (ZnOₓ) und 0,5 bis 8 Atom-% Aluminiumoxid (AlₓO_{y}) und Magnesiumoxid (MgOₓ) umfasst,
zwischen dem Substrat und der Mischoxidschicht und gegebenenfalls über der Silberschicht eine Metalloxidschicht vorgesehen ist bzw. sind, und
die Metalloxidschichten Titanoxid (TiOₓ), Zinnoxid (SnOₓ) und/oder Zinkoxid (ZnOₓ) umfassen.

2. Belag nach Anspruch 1,
**dadurch gekennzeichnet,**
**dass** die Menge von Aluminiumoxid (AlₓO_{y}) und Magnesiumoxid (MgOₓ) in einem Bereich von 1,5 bis 6 Atom-% liegt.

3. Belag nach Anspruch 2,
**dadurch gekennzeichnet,**
**dass** die Menge von Aluminiumoxid (AlₓO_{y}) und Magnesiumoxid (MgOₓ) in einem Bereich von 2,5 bis 4 Atom-% liegt.

4. Belag nach einem der Ansprüche 1 bis 3,
**dadurch gekennzeichnet,**
**dass** das transparente Substrat aus Glas oder Kunststoff gebildet ist.

5. Belag nach Anspruch 4,
**dadurch gekennzeichnet,**
**dass** das transparente Substrat eine Glasscheibe ist.

6. Belag nach einem der Ansprüche 1 bis 5,
**dadurch gekennzeichnet,**
**dass** die Silberschicht eine Dicke von 10 nm bis 25 nm aufweist.

7. Belag nach einem der Ansprüche 1 bis 6,
**dadurch gekennzeichnet,**
**dass** die Dicke der Metalloxidschicht(en) in einem Bereich von 25 nm bis 35 nm liegt.

8. Verfahren zur Herstellung eines wärmereflektierenden Belags nach einem der Ansprüche 1 bis 7 durch Kathodenzerstäubung.

9. Verfahren nach Anspruch 8,
**dadurch gekennzeichnet,**
**dass** als Target ein Zinkoxidtarget, das Aluminium-und/oder Magnesiumoxid enthält, verwendet wird.

10. Verfahren nach Anspruch 8 und/oder 9,
**dadurch gekennzeichnet,**
**dass** in einem Sauerstoffplasma gearbeitet wird.

11. Verfahren nach Anspruch 10,
**dadurch gekennzeichnet,**
**dass** die Mischoxidschicht abschließend mit einem Sauerstoffplasma behandelt wird.

## Claims

1. Heat-reflective coating for a transparent substrate having a layer comprising a zinc (Zn)-containing mixed oxide arranged on the substrate and a silver (Ag)-containing layer arranged over it,
**characterised in that**
the mixed oxide comprises from 99.5 to 92 at.% zinc oxide (ZnOₓ) and from 0.5 to 8 at.% aluminium oxide (AlₓO_{y}) and magnesium oxide (MgOₓ),
a metal oxide layer is provided between the substrate and the mixed oxide layer and optionally over the silver layer, and
the metal oxide layers comprise titanium oxide (TiOₓ), tin oxide (SnOₓ) and/or zinc oxide (ZnOₓ).

2. Coating according to claim 1,
**characterised in that**
the amount of aluminium oxide (AlₓO_{y}) and magnesium oxide (MgOₓ) is in a range from 1.5 to 6 at.%.

3. Coating according to claim 2,
**characterised in that**
the amount of aluminium oxide (AlₓO_{y}) and magnesium oxide (MgOₓ) is in a range from 2.5 to 4 at.%.

4. Coating according to any one of claims 1 to 3,
**characterised in that**
the transparent substrate is formed of glass or plastics material.

5. Coating according to claim 4,
**characterised in that**
the transparent layer is a pane of glass.

6. Coating according to any one of claims 1 to 5,
**characterised in that**
the silver layer has a thickness of from 10 nm to 25 nm.

7. Coating according to any one of claims 1 to 6,
**characterised in that**
the thickness of the metal oxide layer(s) is in a range from 25 nm to 35 nm.

8. Method for producing a heat-reflective coating according to any one of claims 1 to 7 by cathode sputtering.

9. Method according to claim 8,
**characterised in that**
the target used is a zinc oxide target which contains aluminium oxide and/or magnesium oxide.

10. Method according to claim 8 and/or 9,
**characterised in that**
the operation is carried out in an oxygen plasma.

11. Method according to claim 10,
**characterised in that**
the mixed oxide layer is subsequently treated with an oxygen plasma.

## Revendications

1. Revêtement réflecteur de chaleur destiné à un substrat transparent, comprenant, agencée sur le substrat, une couche d'un oxyde mixte renfermant du zinc (Zn) et, agencée par-dessus, une couche renfermant de l'argent (Ag),
**caractérisé en ce que**
l'oxyde mixte comprend 99,5 à 92 % d'atomes d'oxyde de zinc (ZnOₓ) et 0,5 à 8 % d'atomes d'oxyde d'aluminium (AlₓO_{y}) et d'oxyde de magnésium (MgOₓ),
une couche d'oxyde métallique est prévue entre le substrat et la couche d'oxyde mixte et, le cas échéant, une telle couche est également prévue par-dessus la couche d'argent, et
les couches d'oxyde métallique renferment de l'oxyde de titane (TiOₓ), de l'oxyde d'étain (SnOₓ) et/ou de l'oxyde de zinc (ZnOₓ).

2. Revêtement selon la revendication 1,
**caractérisé en ce que** la quantité d'oxyde d'aluminium (AlₓO_{y}) et d'oxyde de magnésium (MgOₓ) se situe dans une plage de 1,5 à 6 % d'atomes.

3. Revêtement selon la revendication 2,
**caractérisé en ce que** la quantité d'oxyde d'aluminium (AlₓO_{y}) et d'oxyde de magnésium (MgOₓ) se situe dans une plage de 2,5 à 4 % d'atomes.

4. Revêtement selon l'une des revendications 1 à 3,
**caractérisé en ce que** le substrat transparent est formé de verre ou de matière plastique.

5. Revêtement selon la revendication 4,
**caractérisé en ce que** le substrat transparent est une vitre de verre.

6. Revêtement selon l'une des revendications 1 à 5,
**caractérisé en ce que** la couche d'argent présente une épaisseur de 10 nm à 25 nm.

7. Revêtement selon l'une des revendications 1 à 6,
**caractérisé en ce que** l'épaisseur de la ou des couches(s) d'oxyde métallique, se situe dans une plage de 25 nm à 35 nm.

8. Procédé de fabrication d'un revêtement réflecteur de la chaleur selon l'une des revendications 1 à 7 par pulvérisation cathodique.

9. Procédé selon la revendication 8,
**caractérisé en ce que** l'on utilise en guise de cible, une cible d'oxyde de zinc, qui renferme de l'oxyde d'aluminium et/ou de magnésium.

10. Procédé selon la revendication 8 et/ou 9,
**caractérisé en ce que** l'on travaille dans un plasma d'oxygène.

11. Procédé selon la revendication 10,
**caractérisé en ce que** la couche d'oxyde mixte est traitée en définitive à l'aide d'un plasma d'oxygène.
